# EUROPEAN PATENT SPECIFICATION

(11) **EP 2 065 131 B1**
(45) Date of publication and mention of the grant of the patent: **10.10.2012**
(21) Application number: 08015234.1
(22) Date of filing: 28.08.2008
(51) Int. Cl.: B24B 37/04

(54) **Method of manufacturing wafer carrier**
Verfahren zur Herstellung eines Waferträgers
Procédé de fabrication d'un porte-tranche

(30) Priority: 29.11.2007 KR 20070122655
(43) Date of publication of application: 03.06.2009
(73) Proprietor: Siltron Inc., Gumi-si Gyeongsangbuk-do 730-350 (KR)
(72) Inventor: Lee, Chan-Yong, Gumi-si, Gyeongsangbuk-Do, 730-807 (KR)
(74) Representative: Kuhnen & Wacker

(56) References cited:
- WO-A-2006/115039
- US-A1- 2007 184 662

## Description

### BACKGROUND OF THE INVENTION

### Field of the invention

The present invention relates to a method of manufacturing a wafer carrier, and more particularly, to a method of manufacturing a wafer carrier installed at a double-sided polishing apparatus for polishing both surfaces of a wafer, into which the wafer is inserted in double-sided polishing the wafer.

### Description of the Prior Art

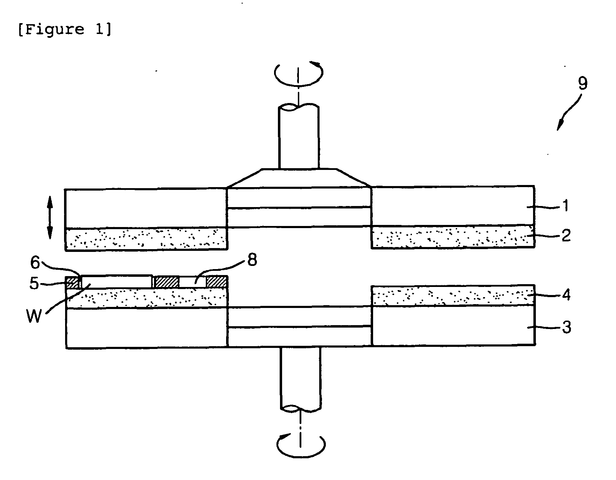

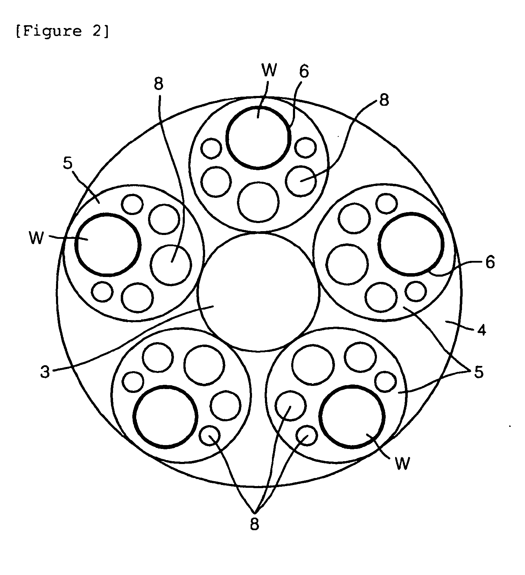

When polishing both surfaces of a wafer, a double-sided polishing apparatus as shown in FIGS. 1 and 2 is used. Referring to FIGS. 1 and 2, a conventional polishing apparatus 9 includes an upper plate 1 and a lower plate 3, which rotate in opposite directions. Polishing pads 2 and 4 are attached on a lower surface of the upper plate 1 and an upper surface of the lower plate 3 to polish upper and lower surfaces of a wafer w, respectively. In addition, a plurality of wafer carriers 5 are supported and mounted between the upper plate 1 and the lower plate 3 as shown in FIG. 2. Each of the wafer carriers 5, which has a disc shape, includes a wafer retaining hole 6 in which the wafer w is inserted and retained, and five slurry introduction holes 8 disposed around the wafer retaining hole 6 and having different sizes from each other.

Meanwhile, in recent times, in order to increase abrasion resistance of the wafer carrier 5, the wafer carrier 5 has been coated with diamond-like carbon (DLC).

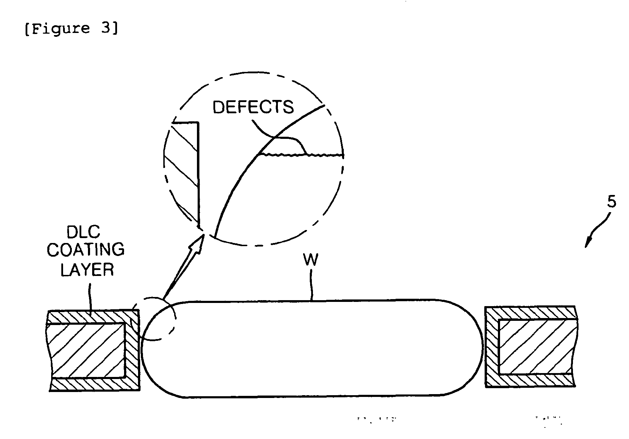

However, as shown in FIG. 3, since the wafer carrier is coated with DLC to an inner surface of the wafer retaining hole formed therein, an edge of the wafer may contact the DLC coating layer during double-sided polishing of the wafer. Therefore, the edge of the wafer may be damaged by the DLC coating layer to cause defects of the wafer.

From prior art document US 2007/0184662 A1 there is known a method for manufacturing a double-side polishing carrier according to the preamble of claim 1.

From WO 2006/116039 A1 there is known a carrier for double-side polishing which comprises a wafer retaining hole and slurry introduction holes.

### SUMMARY OF THE INVENTION

An aspect of the present invention is to provide a method of manufacturing an improved wafer carrier capable of providing good abrasion resistance to remarkably increase lifespan of the carrier and preventing occurrence of defects to an edge of a wafer during double-sided polishing of the wafer.

The invention provides a method, as per claim 1, of manufacturing a wafer carrier, which is installed at a double-sided polishing apparatus for polishing both surfaces of a wafer, the method including: machining a carrier body constituting the wafer carrier in a pre-set shape; forming a preliminary hole and a slurry introduction hole in the carrier body of the wafer carrier; coating diamond-like carbon (DLC) on the carrier body having the preliminary hole; and, after coating the DLC, enlarging the preliminary hole to form a wafer retaining hole, into which the wafer is inserted.

In accordance with the present invention, the method may further include, after forming the preliminary hole and before coating the DLC, attaching mark members to at least one of a front surface and a rear surface of the carrier body such that the members are spaced apart the same distance from a center point of the preliminary hole. At this time, at least four mark members may be radially disposed about a center point of the preliminary hole.

### BRIEF DESCRIPTION OF THE DRAWINGS

The above and other objects, features and advantages of the present invention will be more apparent from the following detailed description taken in conjunction with the accompanying drawings, in which:
FIG. 1 is a schematic view of a conventional wafer carrier;
FIG. 2 is a plan view of the conventional wafer carrier shown in FIG. 1, in which a plurality of wafer carriers are mounted on a lower plate;
FIG. 3 is a schematic cross-sectional view taken along line III-III of FIG. 2;
FIG. 4 is a flowchart showing a method of manufacturing a wafer carrier in accordance with an exemplary embodiment of the present invention;
FIG. 5 is a plan view of a wafer carrier body, showing mark members shown in FIG. 4; and
FIG. 6 is a schematic cross-sectional view taken along line VI-VI of FIG. 5, showing a wafer carrier having a DLC coating layer.

### DETAILED DESCRIPTION OF EXEMPLARY EMBODIMENTS

Hereinafter, exemplary embodiments of the present invention will be described with reference to the accompanying drawings.

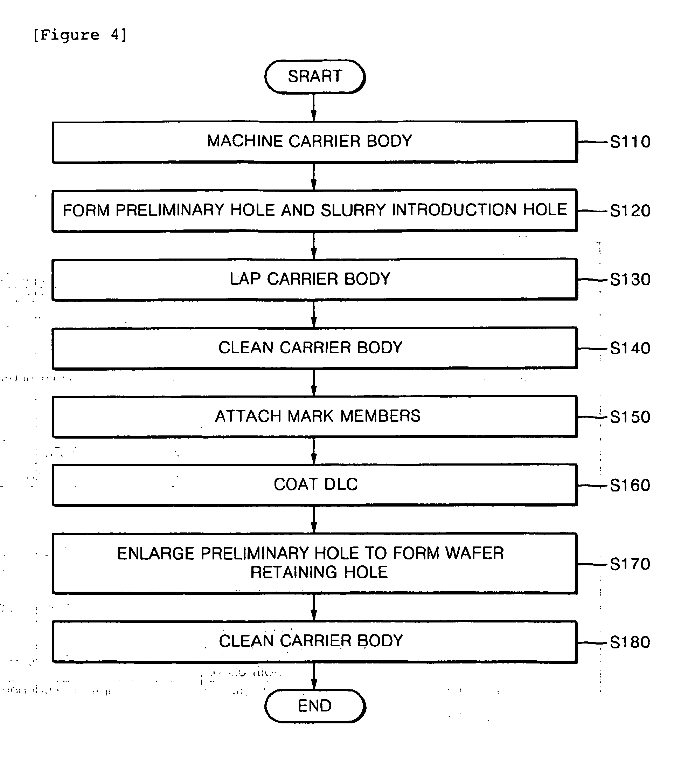

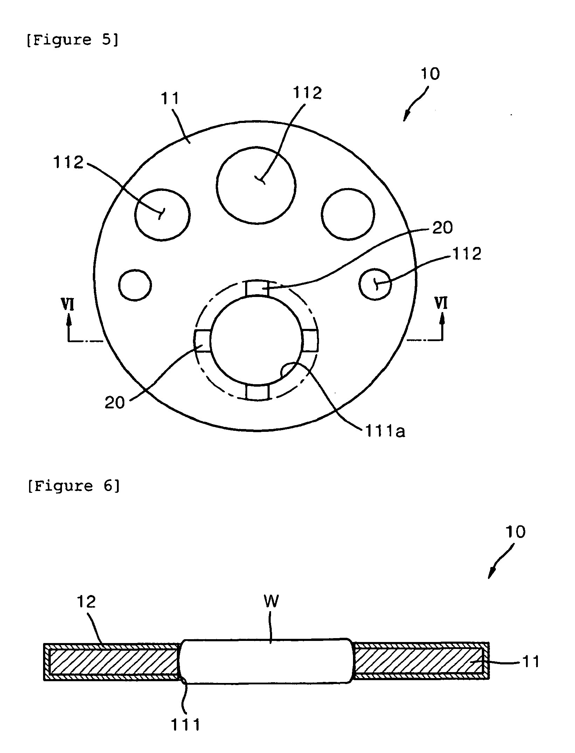

FIG. 4 is a flowchart showing a method of manufacturing a wafer carrier in accordance with an exemplary embodiment of the present invention, FIG. 5 is a plan view of a wafer carrier body, showing mark members shown in FIG. 4, and FIG. 6 is a schematic cross-sectional view taken along line VI-VI of FIG. 5, showing a wafer carrier having a DLC coating layer.

Referring to FIGS. 4 to 6, a method of manufacturing a wafer carrier in accordance with an exemplary embodiment of the present invention is for the purpose of manufacturing a wafer carrier installed at the double-sided polishing apparatus described in Description of the Prior art. The method of manufacturing a wafer carrier includes a machining step S110, a forming step S120, a lapping step S130, an attachment step S150, a coating step S160, and a wafer retaining hole forming step S170, which are sequentially performed.

In the machining step 110, a carrier body 11 constituting a wafer carrier 10 is machined in a pre-set shape. Here, the carrier body 11 is generally formed of an epoxy glass plate. In addition, epoxy glass is routed in a pre-set shape, for example, a circular shape, to form the carrier body 11 of the wafer carrier.

In the forming step S120, a single preliminary hole 111a and a plurality of slurry introduction holes 112 are formed in the routed carrier body 11. The preliminary hole 111a has a diameter smaller than that of a wafer retaining hole 111, which will be described. For example, when the wafer retaining hole 111 has a diameter of 300mm, the preliminary hole 111a may have a diameter of 290mm or less.

In the lapping step S130, the carrier body 11 is lapped using a lapping agent. After the lapping step is completed, the carrier body 11 is cleaned (S140).

In the attachment step S150, mark members 20 are attached to the carrier body 11 having the preliminary hole 111a. The mark members 20 may be formed of any material attachable to the carrier body 11. In general, for the mark members 20, a tape, which is inexpensive and readily available, may be used. The mark members 20 are attached to at least one surface of front and rear surfaces of the carrier body 11, and, in this embodiment in particular, four mark members 20 are attached to the front surface of the carrier body 11. Centers of the mark members 20 are spaced apart the same distance from a center point of the preliminary hole 111a. Therefore, the four mark members 20 are radially disposed about the center point of the preliminary hole 111a. In addition, one edge of the edges of each mark member far from the center point of the preliminary hole 111a has an arc shape. In particular, arc-shaped edges of the four mark members 20 form portions of one circumference. At this time, when the mark members 20 are set to an appropriate size, the edges of the mark members 20 are connected to each other such that the connected circle becomes the wafer retaining hole 111, which will be described.

In the coating step S160, DLC is coated on the carrier body 11, to which the mark members 20 are attached, to form a DLC coating layer 12. The DLC coating layer 12 is formed on the mark members 20 as well as the carrier body 11. The DLC coating layer 12 is formed by a generally known deposition method such as a sputtering method.

In the wafer retaining hole forming step S170, a wafer retaining hole 111 is formed in the carrier body 11 on which the DLC coating layer 12 is formed. That is, the preliminary hole 111a is enlarged to form the wafer retaining hole 111 having the same center point as the preliminary hole 111a. At this time, the preliminary hole 111a is enlarged until the mark members 20 are entirely removed. In particular, when the preliminary hole 111a is enlarged until the mark members 20 are removed to the arc-shaped edges, it is possible to form the wafer retaining hole 111 having a desired diameter. As described above, when the preliminary hole 111a is enlarged, as shown in FIG. 6, there is no DLC coating layer on an inner surface of the wafer retaining hole 111. After the enlargement of the preliminary hole 111a, a cleaning step S180 is performed.

As described above, when the method of manufacturing a wafer carrier of the embodiment is used, since the DLC coating layer 12 is not formed on the inner surface of the wafer retaining hole 111 of the wafer carrier, it is possible, unlike the conventional art, to prevent damage to an edge of the wafer w during double-sided polishing of the wafer w. Therefore, it is possible, unlike the conventional art, to improve abrasion resistance of the wafer carrier 10 using the DLC coating layer and prevent damage to the wafer during double-sided polishing of the wafer w, thereby improving quality of the wafer. In addition, lifespan of the wafer carrier can be remarkably increased.

In particular, when arc-shaped edges of the four mark members are connected to each other to form the wafer retaining hole, it is possible to readily form the wafer retaining hole by enlarging the preliminary hole to the edges of the mark members 20 without measuring the dimension of the enlargement.

While an exemplary embodiment in accordance with the present invention has been described, the present invention not being limited thereto, it will be apparent to those skilled in the art that various modifications may be made without departing from the claims.

For example, while the embodiment has been described to include attaching the mark members, but not limited thereto, the preliminary hole may be enlarged just after coating the DLC to form the wafer retaining hole, without attaching the mark members.

In addition, while the embodiment has been described such that the edges of the mark members form portions of arcs, the edges of the mark members need not be used to form the portions of the arcs. That is, after forming the mark members in a polygon such as a square, an imaginary straight line from an apex of the mark member to a center of the preliminary hole may be set as a radius of the wafer retaining hole such that the preliminary hole is enlarged.

As can be seen from the foregoing, since a wafer carrier is coated with DLC having good abrasion resistance, it is possible to remarkably increase lifespan of the wafer carrier. In addition, since the DLC coating layer is not formed on an inner surface of a wafer retaining hole of the wafer carrier, it is possible to prevent damage to an edge of the wafer due to contact with the DLC coating layer during double-sided polishing of the wafer.

While this invention has been described with reference to exemplary embodiments thereof, it will be clear to those of ordinary skill in the art to which the invention pertains that various modifications may be made to the described embodiments without departing from the invention as defined in the appended claims.

## Claims

1. A method of manufacturing a wafer carrier (10), which is installed at a double-sided polishing apparatus (9) for polishing both surfaces of a wafer (W), the method comprising:
machining (S110) a carrier body (11) constituting the wafer carrier in a pre-set shape;
forming (S120) a preliminary hole (111a) in the carrier body (11) of the wafer carrier;
coating (S160) diamond-like carbon (DLC) on the carrier body (11) having the preliminary hole (111a),
**characterized in that**
a slurry introduction hole (112) is formed in the carrier body (11) before coating diamond-like carbon (DLC) on the carrier body (11), and
the method further comprises, after coating the DLC, enlarging (S170) the preliminary hole (111a) to form a wafer retaining hole (111), into which the wafer (W) is inserted.

2. The method according to claim 1, further comprising, after forming the preliminary hole (111a) and before coating the DLC, attaching ((S150) mark members (20) to at least one of a front surface and a rear surface of the carrier body such that the members are spaced apart the same distance from a center point of the preliminary hole (111a).

3. The method of according to claim 2, wherein at least four mark members (20) are radially disposed about a center point of the preliminary hole (111a).

## Patentansprüche

1. Verfahren zum Herstellen eines Wafer-Trägers (10), der an einer doppelseitigen Poliervorrichtung (9) zum Polieren beider Oberflächen eines Wafers (W) installiert ist, wobei das Verfahren folgende Schritte beinhaltet:
maschinelles Bearbeiten (S110) eines Trägerkörpers (11), der den Waferträger in einer voreingestellten Form darstellt;
Ausbilden (S 120) eines vorläufigen Lochs (111a) in dem Trägerkörper (11) des Waferträgers;
Beschichten (S160) des Trägerkörpers (11) mit dem vorläufigen Loch (111a) mit diamantförmigem Kohlenstoff (DLC),
**dadurch gekennzeichnet, dass**
ein Slurry-Einführloch (112) in dem Trägerkörper (11) vor dem Beschichten des Trägerkörpers (11) mit diamantförmigem Kohlenstoff (DLC) ausgebildet wird, und
das Verfahren ferner, nach dem Beschichten mit DLC, ein Vergrößern (S 170) des vorläufigen Lochs(111a) beinhaltet, um ein Waferaufnahmeloch(111) auszubilden, in das der Wafer (W) eingefügt wird.

2. Verfahren nach Anspruch 1, das ferner, nach dem Ausbilden des vorläufigen Lochs(111a) und vor dem Auftragen mit DLC, ein Anbringen(S150) von Markierungselementen (20) auf zumindest einer vorderen Oberfläche und einer hinteren Oberfläche des Trägerkörpers beinhaltet, so dass die Elemente um den gleichen Abstand von einem Mittelpunkt des vorläufigen Lochs(111a) beabstandet sind.

3. Verfahren nach Anspruch 2, wobei zumindest vier Markierungselemente (20) um einen Mittelpunkt des vorläufigen Lochs (111a) radial angeordnet werden.

## Revendications

1. Procédé de fabrication d'un porte-tranche (10) qui est installé sur un appareil de polissage double face (9) pour le polissage des deux surfaces d'une tranche (W), le procédé comprenant les étapes suivantes :
usiner (S110) un corps porteur (11) constituant le porte-tranche dans une forme prédéfinie ;
former (S120) un trou préliminaire (111a) dans le corps porteur (11) du porte-tranche ;
revêtir (S160) de carbone de type diamant (DLC) le corps porteur (11) présentant le trou préliminaire (111a),
**caractérisé en ce que**
un trou d'introduction de pâte épaisse (112) est formé dans le corps porteur (11) avant le revêtement de carbone de type diamant (DLC) sur le corps porteur (11), et
le procédé comprend en outre, après le revêtement de DLC, l'agrandissement (S170) du trou préliminaire (111a) pour former un trou de retenue de tranche (111), dans lequel la tranche (W) est insérée.

2. Procédé selon la revendication 1, comprenant en outre après la formation du trou préliminaire (111a) et avant le revêtement de DLC, la fixation (S150) des éléments de marquage (20) sur au moins une surface parmi une surface avant et une surface arrière du corps porteur de sorte que les éléments soient espacés de la même distance d'un point central du trou préliminaire (111a).

3. Procédé selon la revendication 2, dans lequel au moins quatre éléments de marquage (20) sont disposés dans le sens radial autour d'un point central du trou préliminaire (111a).
